# EUROPEAN PATENT APPLICATION

(11) **EP 4 113 627 A1**
(43) Date of publication of application: **04.01.2023**
(21) Application number: 20938913.9
(22) Date of filing: 30.05.2020
(51) Int. Cl.: H01L 29/78, H01L 21/822

(54) **GALLIUM NITRIDE-BASED CHIP, CHIP MANUFACTURING METHOD, GALLIUM NITRIDE POWER DEVICE, AND CIRCUIT**

(71) Applicant: Huawei Digital Power Technologies Co., Ltd., Shenzhen, Guangdong 518043 (CN)
(72) Inventor: HOU, Zhaozheng, Shenzhen, Guangdong 518129 (CN); WANG, Hanxing, Shenzhen, Guangdong 518129 (CN); TANG, Gaofei, Shenzhen, Guangdong 518129 (CN)
(74) Representative: Grünecker Patent- und Rechtsanwälte PartG mbB
(86) International application number: PCT/CN2020/093576
(87) International publication number: WO 2021/243482

(57) **Abstract**

This application provides a chip, a gallium nitride power device, and a power drive circuit. The chip includes a substrate and a plurality of gallium nitride components disposed on the substrate. The plurality of gallium nitride components are arranged in an array. The gallium nitride component includes an active region and a non-active region separately disposed on the substrate. The non-active region surrounds a side surface of the active region. The active region includes a heterojunction formed by a gallium nitride layer and an aluminum gallium nitride layer. The non-active region includes a plurality of grooves spaced apart. The plurality of grooves penetrate the non-active region and expose the substrate, and the plurality of grooves are used to isolate adjacent gallium nitride components.

## Description

### TECHNICAL FIELD

This application relates to the field of chip technologies, and in particular, to a gallium nitride-based chip, a chip preparation method, a gallium nitride power device, and a circuit.

### BACKGROUND

With a trend of high efficiency and miniaturization of a power converter, a power switching device prepared based on a wide-bandgap semiconductor material gallium nitride is widely used. A gallium nitride transistor is mainly based on a heterojunction formed by aluminum gallium nitride (AlGaN) and gallium nitride (GaN). This heterostructure naturally forms a layer of two-dimensional electron gas (2DEG) on an interface of the heterostructure. An electron mobility of the 2DEG is high, and excellent conductivity can be implemented, so that the transistor has a smaller chip area in a case of same on resistance. In addition, gallium nitride material has high-voltage resistance and high-temperature resistance due to its characteristics of high breakdown electric field and wide bandgap.

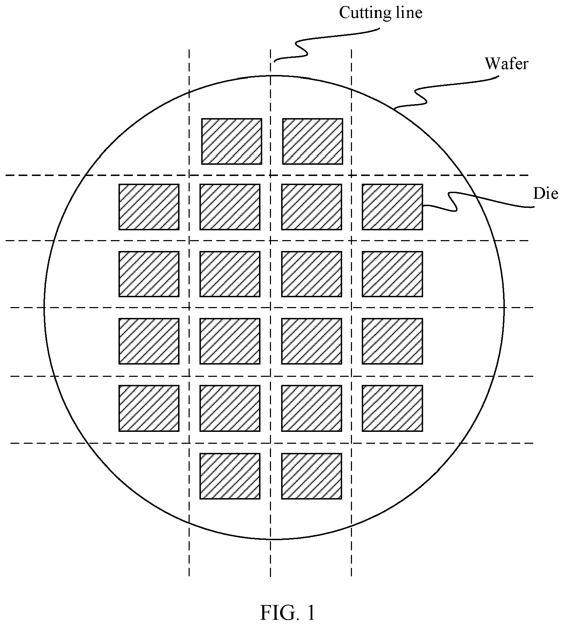

Generally, a gallium nitride transistor is formed on a wafer (wafer) of a material such as silicon. Before the gallium nitride transistor is encapsulated to form a gallium nitride power device, the wafer usually needs to be cut to obtain a die (die) of the gallium nitride transistor. FIG. 1 is a schematic diagram of cutting of a wafer according to the conventional technology. A wafer includes a plurality of gallium nitride transistors arranged in an array, and adjacent gallium nitride transistors need to include enough distance for a dicing knife to cut the wafer. In a cutting process, because of a cutting stress, a crack in a structure of a gallium nitride transistor layer inevitably occurs, and device performance deteriorates.

### SUMMARY

Embodiments of this application provide a gallium nitride-based chip, a chip preparation method, a gallium nitride power device, and a circuit, so as to resolve a technical problem that a structure of a gallium nitride transistor layer is inevitably cracked due to a cutting stress, thereby causing degradation of device performance.

According to a first aspect, an embodiment of this application provides a gallium nitride-based chip, including: a substrate, and a plurality of gallium nitride components disposed on the substrate, where the plurality of gallium nitride components are arranged in an array and each gallium nitride component of the plurality of gallium nitride components includes an active region and a non-active region respectively disposed on the substrate. The non-active region surrounds a side surface of the active region, the active region includes at least one heterojunction formed by a gallium nitride layer and an aluminum gallium nitride layer, the non-active region includes a plurality of grooves spaced apart, the plurality of grooves penetrate the non-active region and expose the substrate, and the plurality of grooves are configured to isolate adjacent gallium nitride components.

The foregoing chip blocks a connection of adjacent gallium nitride components on the chip by using grooves disposed around the gallium nitride components, so as to avoid a crack of a GaN epitaxial layer caused by a cutting stress when cutting the chip, to avoid decrease in electrical performance of the gallium nitride component, and to improve reliability of a device prepared by the foregoing chip. In addition, because the grooves block the connection of adjacent gallium nitride components, a CP test cost can be reduced without skipping a "die" interval test when the chip performs a CP test.

In a possible implementation, a ratio of a sum of areas of the plurality of grooves to an area of the non-active region is not less than 2/3.

In a possible implementation, the non-active region further includes a metal stack, and the metal stack includes at least one metal layer stacked at intervals in a first direction. Each metal layer of the at least one metal layer is annular, and each metal layer is disposed between the multiple grooves and the active region.

In a possible implementation, the gallium nitride layer includes a first gallium nitride portion and a second gallium nitride portion that are both disposed on the substrate, the aluminum gallium nitride layer is disposed on a surface of the first gallium nitride portion that is away from the substrate, and the first gallium nitride portion and the aluminum gallium nitride layer form the heterojunction. The non-active region includes the second gallium nitride portion, and the groove penetrates the first gallium nitride portion.

Optionally, the active region further includes a source, a drain, and a gate, where the source and the drain are respectively connected to two ends of the first gallium nitride portion, and the gate is connected to the aluminum gallium nitride layer.

In a possible implementation, the active region further includes a source, a drain, a gate, and a P-type gallium nitride layer, where the P-type gallium nitride layer is disposed on a surface of the aluminum gallium nitride layer that is away from the first gallium nitride portion, the source and the drain are respectively connected to two ends of the first gallium nitride portion, and the gate is connected to the P-type gallium nitride layer.

Optionally, the gallium nitride component further includes a medium layer that covers the aluminum gallium nitride layer and the second gallium nitride portion, where the medium layer includes a first medium portion and a second medium portion, the first dielectric portion is a portion that is in the medium layer and corresponding to the first gallium nitride portion, and the second dielectric portion is a portion that is in the medium layer and corresponding to the second gallium nitride portion. The source is connected to one end of the first gallium nitride portion by using a first via through the medium layer, the drain is connected to the other end of the first gallium nitride portion by using a second via through the medium layer, the gate is connected to the P-type gallium nitride layer by using a third via through the medium layer, the non-active region includes the second dielectric portion, and the groove further penetrates the second dielectric portion.

In a possible implementation, the gallium nitride component further includes a passivation layer, where the passivation layer is disposed on a surface of the dielectric layer that is away from the substrate, and the passivation layer is provided with a via used to expose the source, the drain, and the gate. The groove further penetrates the passivation layer.

In a possible implementation, the gallium nitride component further includes a transition layer, where the transition layer is disposed between the substrate and the gallium nitride layer, a lattice constant of the transition layer is located between a lattice constant of the substrate and a lattice constant of the gallium nitride layer, and the groove further penetrates the transition layer.

In a possible implementation, adjacent two of the gallium nitride components further include a cutting area.

According to a second aspect, an embodiment of this application further provides a gallium nitride power device, including the gallium nitride component obtained through cutting of the chip according to any one of the first aspect or the possible implementations of the first aspect.

According to a third aspect, an embodiment of this application further provides a circuit, where the circuit includes any gallium nitride power device according to the second aspect.

Optionally, the circuit may be a power conversion circuit, and is applied to a power adapter.

According to a fourth aspect, an embodiment of this application further provides a chip preparation method, where the method includes:
forming a plurality of gallium nitride components on a substrate, where the plurality of gallium nitride components are arranged in an array, and each gallium nitride component of the plurality of gallium nitride components includes an active region and a non-active region respectively disposed on the substrate, where the non-active region surrounds a side surface of the active region, and the active region includes at least one heterojunction formed by a gallium nitride layer and an aluminum gallium nitride layer; and
forming a plurality of grooves on the non-active region, where the plurality of grooves penetrate the non-active region and expose the substrate, and the plurality of grooves are configured to isolate adjacent gallium nitride components.

In a possible implementation, an implementation in which a plurality of grooves are formed on the non-active region may include:
forming a patterned photoresist layer away from a surface of the substrate in the non-active area; and
using the patterned photoresist layer as a mask, etching the non-active region, and exposing the substrate to obtain the plurality of grooves.

### BRIEF DESCRIPTION OF DRAWINGS

To describe the technical solutions in embodiments of this application or in the conventional technology more clearly, the following briefly describes the accompanying drawings used in describing the embodiments or the conventional technology.
FIG. 1 is a schematic diagram of cutting of a wafer according to the conventional technology;
FIG. 2A is a schematic diagram of a preparation process of a gallium nitride power device according to an embodiment of this application;
FIG. 2B is a schematic diagram of a structure of a gallium nitride transistor according to an embodiment of this application;
FIG. 2C is a schematic diagram of a structure of another gallium nitride transistor according to an embodiment of this application;
FIG. 3 is a schematic diagram of a structure of a chip including a gallium nitride transistor according to an embodiment of this application;
FIG. 4 is a schematic cross-sectional view of a gallium nitride component along a line A-B shown in FIG. 3 according to an embodiment of this application;
FIG. 5A is a schematic cross-sectional view of a gallium nitride component along a line A-B shown in FIG. 3 according to an embodiment of this application;
FIG. 5B is a schematic cross-sectional view of another gallium nitride component along the line A-B shown in FIG. 3 according to an embodiment of this application;
FIG. 6 is a schematic diagram of a structure of another gallium nitride component according to an embodiment of this application;
FIG. 7 is a schematic cross-sectional view of a gallium nitride component along a line C-D shown in FIG. 6 according to an embodiment of this application; and
FIG. 8 is a schematic flowchart of a chip preparation method according to an embodiment of this application.

### DESCRIPTION OF EMBODIMENTS

The following clearly describes the technical solutions in embodiments of this application with reference to the accompanying drawings in embodiments of this application.

A sequence number of a component in this application, such as "first" and "second", is merely used to distinguish the described objects, and does not have any sequence or technical meaning. "Connection" in this application includes direct connection and indirect connection unless otherwise specified. In the description of this application, it should be understood that a direction or a location relationship indicated by the terms "up", "down", "front", "back", "left", "right", "vertical", "horizontal", "top", "bottom", "inside", "outside" are based on a direction or a location relationship shown in accompanying drawings, and is merely for ease of description and simplification of this application, and is not intended to indicate or imply that referred apparatus or element must have a specific direction, or be constructed or operated in a specific direction. Therefore, this is not understood as a limitation of this application.

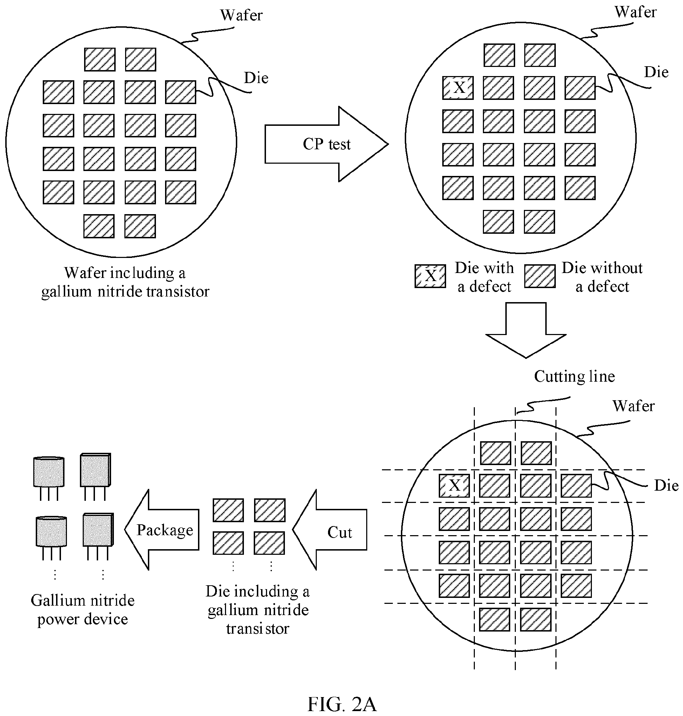

With reference to FIG. 2A, the following describes a preparation process of a gallium nitride power device related to this application.

### (1) Obtain a wafer including gallium nitride transistors through preparation.

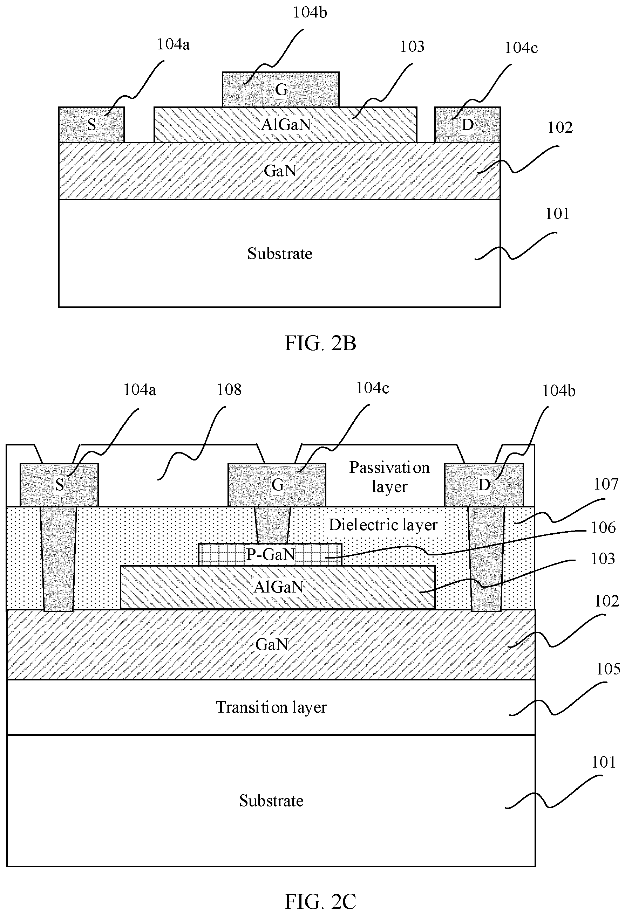

A gallium nitride transistor may be formed on a substrate (such as a silicon substrate) by using a semiconductor preparation process. As shown in FIG. 2A, a wafer includes a plurality of dies, and each die includes one or more gallium nitride transistors. It should be understood that a die is a smallest repeating unit in a wafer, and a sufficient distance needs to be left between repeatedly arranged dies for a dicing knife to cut the wafer. Please refer to schematic diagrams of structures of two gallium nitride transistors shown in FIG. 2B and FIG. 2C.

As shown in a schematic diagram of a structure of the gallium nitride transistor in FIG. 2A, a gallium nitride (GaN) layer 102 and an aluminum gallium nitride (AlGaN) layer 103 are sequentially laminated on a substrate 101, a source (S) 104a and a drain (D) 104b are respectively connected to two ends of the gallium nitride layer 102, and a gate (G) 104c is connected to a surface that is of the aluminum gallium nitride layer 103 and that is away from the gallium nitride layer 102.

Optionally, the gallium nitride transistor may further include another layer structure. As shown in a schematic diagram of a structure of the gallium nitride transistor shown in FIG. 2C, a transition layer 105, a gallium nitride (GaN) layer 102, an aluminum gallium nitride (AlGaN) layer 103, a P-type GaN layer 106, a medium layer 107, and a passivation layer 108 are sequentially laminated on a substrate 101. A source (S) 104a and a drain (D) 104b are connected to two ends of the gallium nitride layer 102 by using a via, and a gate (G) 104c is connected to the P-type GaN layer 106 by using a via. It should be understood that P-type GaN refers to p-type doped gallium nitride.

The gallium nitride (GaN) layer 102, the aluminum gallium nitride (AlGaN) layer 103, the P-type GaN layer 106, or the gallium nitride (GaN) layer 102 and the aluminum gallium nitride (AlGaN) layer 103 may be collectively referred to as a GaN epitaxial layer or an epitaxial layer, and are a core layer structure of the gallium nitride transistor.

The passivation layer 108 is an insulating material, and is used to protect an internal layer structure (for example, the dielectric layer 107 or the GaN epitaxial layer) from deterioration of the internal layer structure caused by entry of external oxygen, water vapor into the internal layer structure, or reduce a defect of the internal layer structure caused by a crack of the internal layer structure under a mechanical stress such as subsequent cutting, thereby causing degradation of electrical performance of the gallium nitride transistor.

The dielectric layer 107 is an insulating material, and the transition layer 105 is used to reduce an internal stress of the GaN layer 102 due to a lattice constant mismatch between the GaN layer 102 and the substrate 101.

It should be understood that the transition layer 105, the dielectric layer 107, the passivation layer 108, and the like are not required layer structures of the gallium nitride transistor provided in embodiments of this application. In some embodiments, the gallium nitride transistor may not include one or a combination of the transition layer 105, the dielectric layer 107, the passivation layer 108, and the like. It should be further understood that the gallium nitride transistor may further include another layer structure, for example, a multilayer metal layer located in the dielectric layer, where the multilayer metal layer is used to connect the source 104a, the drain 104b, and the 104c to the gallium nitride epitaxial layer.

### (2) CP (chip probing) test.

It should be understood that after a wafer that includes gallium nitride transistors is obtained through preparation, a CP (chip probing) test needs to be performed on the wafer, so as to determine a bad die in the wafer, and reduce costs of encapsulation and testing in a process of encapsulating dies. Yield of the wafer can be obtained through the CP test.

The CP test is to test each die in the wafer. The basic principle of the CP test is that a probe adds a signal to stimulate the die in the wafer, and then tests its threshold voltage, on resistance, source-drain breakdown voltage, a gate-source-drain current, and a source-drain current are tested.

For the wafer shown in FIG. 1, when the CP test is performed, because of connection between epitaxial layers, tests between adjacent dies interfere with each other, which is mainly manifested in:
(a) After a hipot test is performed on the gallium nitride device, a gallium nitride device in the peripheral area will drift its original component characteristics (for example, threshold voltage drift) due to interference of a test stress. Therefore, during the current CP test, a "skip die" test mode must be adopted, that is, a next chip test is performed by skipping a peripheral area of a current test die.
(b) In order to reduce costs of the CP test and improve efficiency of the CP test, the test is usually performed in a "multi-workstation" mode. However, due to mutual crosstalk between gallium nitride devices, a quantity of CP workstations is limited, and the "skip die" test is required, and therefore the test costs are high.

### (3) Cut the wafer to obtain a die.

After the CP test is performed, it may be determined which dies are qualified and which dies are not qualified. Then, the wafer is cut along a cutting line to obtain dies, and the qualified dies are sent to a next program for encapsulation.

In a process of cutting the wafer, a crack of the passivation layer and/or the epitaxial layer is inevitably caused due to a cutting stress. When the crack extends into an active region of a chip, performance of a device of a transistor is degraded. For example, in a high-temperature and high-moisture reliability test, a leakage current obviously increases, and a direct failure of a chip function is caused if it is serious. Although some hidden cracks do not affect a static parameter of the gallium nitride power device, characteristics of the device decay with aging time during long-term aging.

### (4) Encapsulate the die to obtain a gallium nitride power device.

After a die is obtained through cutting, the die may be encapsulated to obtain a gallium nitride power device. The gallium nitride power device may be applied to a power conversion circuit, a speaker, and the like by using excellent performance such as high electrical conductivity.

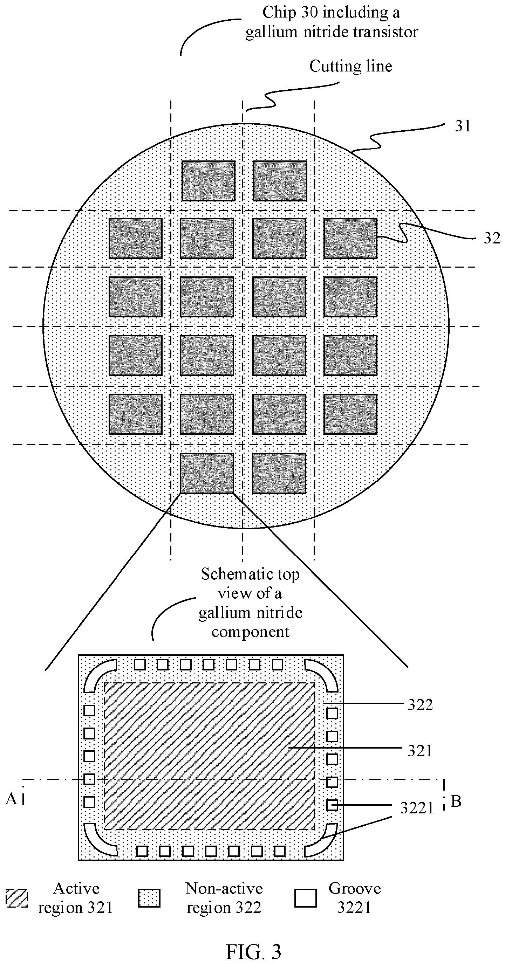

With reference to FIG. 3 to FIG. 7, the following describes a chip that includes a gallium nitride transistor according to an embodiment of this application.

FIG. 3 is a schematic diagram of a structure of a chip including a gallium nitride transistor according to an embodiment of this application. The chip 30 may include a substrate 31 and a plurality of gallium nitride components 32 disposed on the substrate 31, where the plurality of gallium nitride components 32 are arranged in an array. The gallium nitride component 32 includes an active region 321 and a non-active region 322 that are respectively disposed on the substrate 31, where the non-active region 322 surrounds a side surface of the active region 321, the active region 321 includes at least one heterojunction formed by a gallium nitride layer and an aluminum gallium nitride layer, the non-active region 322 includes a plurality of spaced grooves 310, the plurality of grooves 310 penetrate through the non-active region 322 and expose the substrate 31, and the plurality of grooves 310 are used to isolate the gallium nitride component and its adjacent gallium nitride components.

The groove 310 may be formed by etching, and a shape of the groove 310 may be a regular image such as a square, a circle, or an irregular pattern. In addition, for a same gallium nitride component 32, shapes and sizes of grooves 310 of the gallium nitride component 32 may be the same or different, and the foregoing are not limited.

It should be understood that the side surface of the active region 321 refers to a surface that is of the active region 321 and that is perpendicular to the substrate 31.

Optionally, the grooves 310 may be evenly distributed around the active region 321, and distances between any two adjacent grooves 310 may be the same.

Optionally, for a gallium nitride component 32, a ratio of a sum of areas of grooves to an area of a non-active region is not less than a first threshold, where the first threshold may be 2/3, 3/4, 1/2, or the like, and the first threshold is a positive number not greater than 1.

It should be understood that, the chip 30 further includes a cutting area between two adjacent gallium nitride components for cutting to obtain gallium nitride components. The cutting area is used to cut the chip 30 to obtain a die (a gallium nitride component) of and is at a position of the cutting line shown in FIG. 3

In the foregoing chip, connection of adjacent gallium nitride components on the chip is blocked by using grooves disposed around the gallium nitride components, so as to avoid a crack of a GaN epitaxial layer caused by a cutting stress when the chip is being cut, to avoid decrease in electrical performance of the gallium nitride component, and to improve reliability of a device prepared by the gallium nitride component. In addition, because the grooves block the connection of adjacent gallium nitride components, CP test costs can be reduced without skipping a "die" interval test during a CP test on the chip.

This embodiment of this application is described by using an example in which a gallium nitride component 32 includes a gallium nitride transistor, that is, a heterojunction formed by a gallium nitride layer and an aluminum gallium nitride layer is included. It should be understood that, in another implementation, the active region 31 of the silicon nitride component may include a plurality of gallium nitride transistors.

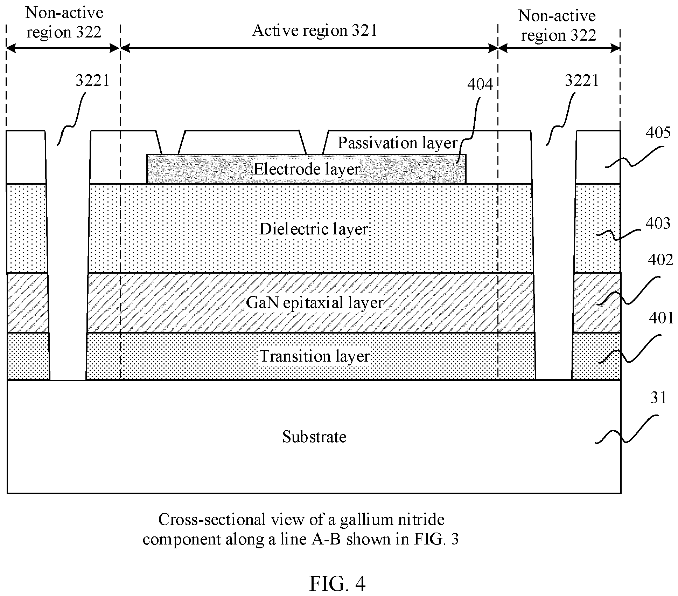

FIG. 4 is a schematic cross-sectional view of a gallium nitride component along a line A-B shown in FIG. 3 according to an embodiment of this application. The gallium nitride component may include a transition layer 401, a GaN epitaxial layer 402, a dielectric layer 403, an electrode layer 404, and a passivation layer 405 that are sequentially disposed on the substrate 31. The foregoing layers may be divided into the active region 321 and the non-active region 322. The transition layer 401, the dielectric layer 403, and the passivation layer 405 are not necessary layers of the gallium nitride component in this application. The passivation layer 405 covers the dielectric layer 403 and partially covers the electrode layer 404. In some embodiments, the passivation layer 405 may also partially fill grooves 3221, for example, cover side surfaces of the grooves 3221.

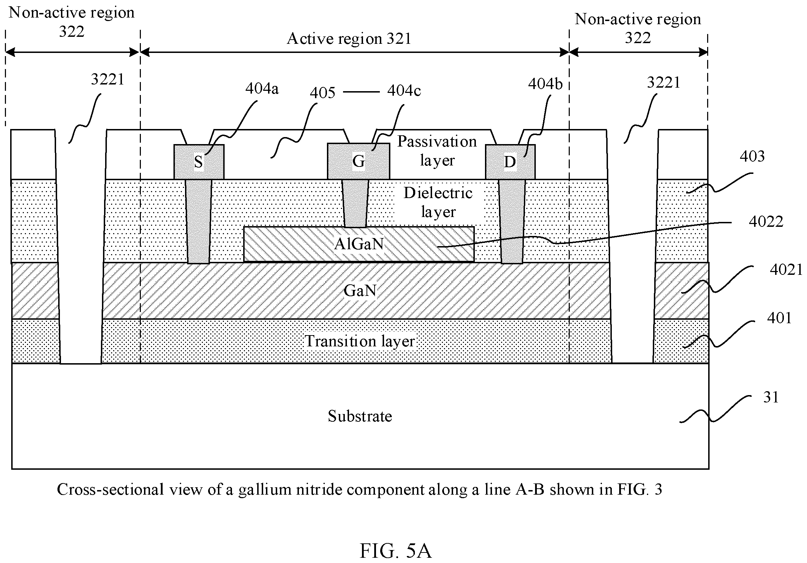

In one implementation, a schematic sectional view of a gallium nitride component shown in FIG. 5A along the line A-B shown in FIG. 3. The GaN epitaxial layer 402 may include a gallium nitride layer 4021, an aluminum gallium nitride layer 4022, and the like. A heterojunction is formed between the gallium nitride layer and the aluminum gallium nitride layer 4022 in the active region 321, and the non-active region 322 may include only the gallium nitride layer. In FIG. 5A, the gallium nitride layer 4021 includes a first gallium nitride portion and a second gallium nitride portion that are both disposed on the substrate, where the first gallium nitride portion is gallium nitride in the active region 321, the second gallium nitride portion is gallium nitride in the non-active region 322, the aluminum gallium nitride layer 4022 is disposed on a surface that is of the first gallium nitride portion and that is away from the substrate, and the first gallium nitride portion and the aluminum gallium nitride layer 4022 form a heterojunction. The non-active region 322 includes the second gallium nitride portion, and grooves 3221 penetrate the first gallium nitride portion. In this case, the electrode layer 404 of the active region 321 further includes a source 404a, a drain 404b, and a gate 404c. The source 404a and the drain 404b are electrically connected to two ends of the first gallium nitride portion, and the gate 404c is electrically connected to the aluminum gallium nitride layer 4022.

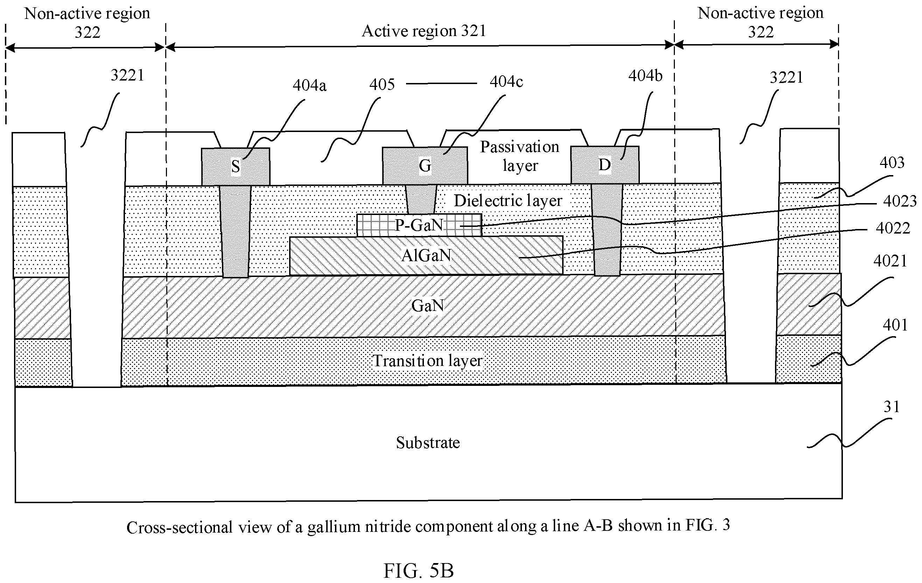

In still another implementation, as shown in FIG. 5B, the GaN epitaxial layer 402 may include the gallium nitride layer 4021, the aluminum gallium nitride layer 4022, a P-type GaN layer 4033, and the like. Different from the foregoing FIG. 5A, the P-type gallium nitride layer 4023 is disposed on a surface that is of the aluminum gallium nitride layer 4022 and that is away from the first gallium nitride portion, and the gate 404c is electrically connected to the aluminum gallium nitride layer 4022.

It should also be understood that the source 404a, the drain 404b, and the gate 404c may be electrically connected to a layer structure in the GaN epitaxial layer 402 by opening a via in the dielectric layer 403 or a metal layer embedded in the dielectric layer 403. For a specific connection relationship, refer to FIG. 5A or FIG. 5B. Details are not described herein again.

As shown in FIG. 4, FIG. 5A, and FIG. 5B, the gallium nitride component may include the passivation layer 405. The passivation layer 405 is disposed on a surface that is of the dielectric layer 403 and that is away from the substrate 31, and the passivation layer 403 may be provided with a via used to expose the source 404a, the drain 404b, and the gate 404c. In this case, the grooves 3221 further penetrate the passivation layer 405.

As shown in FIG. 4, FIG. 5A, and FIG. 5B, the gallium nitride transistor further includes the transition layer 401, and the transition layer 401 is disposed between the substrate 31 and the gallium nitride layer 3021. A lattice constant of the transition layer 401 is located between a lattice constant of the substrate 31 and a lattice constant of the gallium nitride layer 3021. In this case, the grooves 3221 further penetrate the transition layer 401 to expose the substrate 31.

Because the gallium nitride and the substrate (the silicon substrate) have different lattice constants and coefficients of thermal expansion, a lattice constant of growth on a substrate surface is first located in a transition layer of a lattice constant of gallium nitride and a lattice constant of a substrate, which may provide an appropriate substrate for growth of a gallium nitride layer.

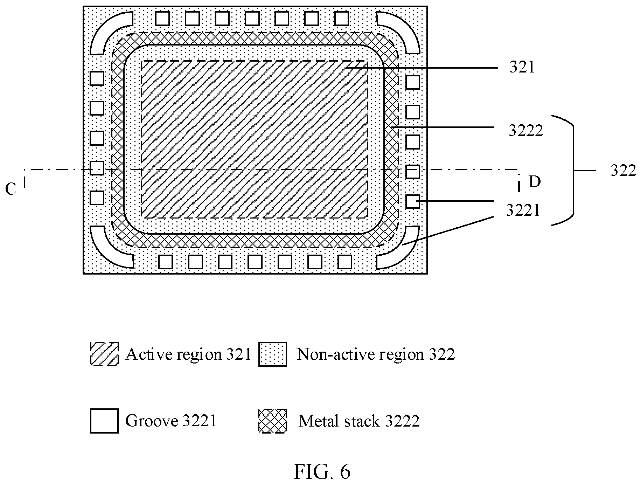

FIG. 6 is a schematic diagram of a structure of another gallium nitride component 32 according to an embodiment of this application. A non-active region 322 of the gallium nitride component 32 may further include a metal stack 3222, and the metal stack 3222 includes at least one metal layer stacked at intervals in a first direction. Optionally, each of the at least one metal layer is annular, and each metal layer is disposed between grooves 3221 and the active region 321. The first direction is perpendicular to an upper surface of the substrate 31.

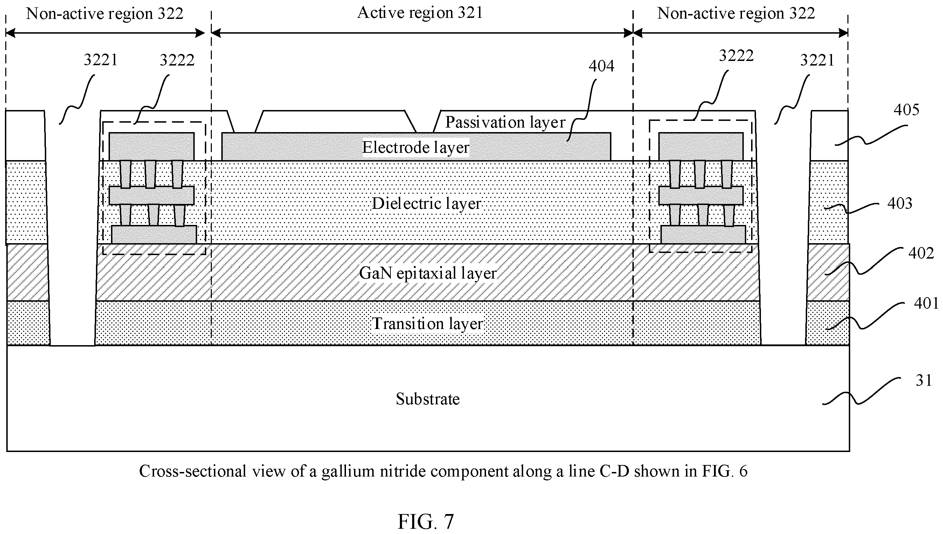

FIG. 7 is a schematic cross-sectional view of a gallium nitride component along a C-D line shown in FIG. 6 according to an embodiment of this application. The gallium nitride component may include a metal stack 3222 in the non-active region 322 except the transition layer 401, the GaN epitaxial layer 402, the dielectric layer 403, the electrode layer 404, and the passivation layer 405 that are sequentially disposed on the substrate 31 shown in FIG. 4. The metal stack 3222 may include at least one metal layer, and the at least one metal layer may be distributed in the dielectric layer 403 and/or the passivation layer 405 in the non-source area 322. Further, adjacent metal layers may be connected by using a via to strengthen the metal stack 3222. In an implementation, the metal stack 3222 in the non-active region 322 and the metal layer coupled with the electrode layer 404 in the active region 321 are not conductive.

It should be noted that the transition layer 401, the dielectric layer 403, and the passivation layer 404 are not necassary layers of the gallium nitride component in this embodiment of this application. It should be understood that the GaN epitaxial layer 402 may include a gallium nitride layer, an aluminum gallium nitride layer, and the like. A heterojunction is formed between the gallium nitride layer and the aluminum gallium nitride layer in the active region 321, and the non-active region 322 may include only the gallium nitride layer. Optionally, the GaN epitaxial layer 402 may also include a gallium nitride layer, an aluminum gallium nitride layer, a P-type GaN layer, and the like. The electrode layer 404 includes a source, a drain, and a gate, and is electrically connected to a layer structure in the GaN epitaxial layer 402 by opening a via in the dielectric layer 403 or a metal layer embedded in the dielectric layer 403. For a specific connection relationship, refer to related descriptions in FIG. 5A or FIG. 5B. Details are not described herein again.

It may be understood that, compared with a chip without the metal stack 3222, the gallium nitride component chip shown in FIG. 6 or FIG. 7 may improve flexibility of the gallium nitride component, reduce a crack of the gallium nitride component caused by cutting the chip, and further improve reliability of the gallium nitride component.

It may be further understood that, compared with the foregoing gallium nitride component chip shown in FIG. 6 or FIG. 7, the chip shown in FIG. 3 or any gallium nitride component chip in FIG. 4 to FIG. 5B, an area of the gallium nitride component can be greatly reduced because no metal stack is disposed, thereby reducing a volume of a gallium nitride power component prepared by the gallium nitride component chip.

An embodiment of this application further provides a gallium nitride power device, and the gallium nitride power device may include the foregoing gallium nitride component obtained by cutting a chip.

An embodiment of this application further provides a circuit, and the circuit includes the foregoing gallium nitride power device. Optionally, the circuit may be a power conversion circuit, and is applied to a power adapter.

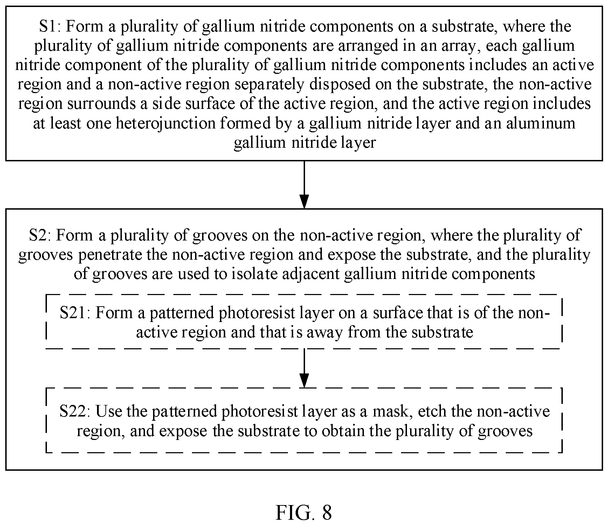

With reference to the flowchart shown in FIG. 8, the following describes a chip preparation method provided in an embodiment of this application. The chip shown in FIG. 3 to FIG. 7 may be prepared in the method and the method may include but is not limited to the following steps.

S1: Form a plurality of gallium nitride components on a substrate, where the plurality of gallium nitride components are arranged in an array, and each gallium nitride component of the plurality of gallium nitride components includes an active region and a non-active region respectively disposed on the substrate, where the non-active region surrounds a side surface of the active region, and the active region includes at least one heterojunction formed by a gallium nitride layer and an aluminum gallium nitride layer.

S2: Form a plurality of grooves on the non-active region, where the plurality of grooves penetrate the non-active region and expose the substrate, and the plurality of grooves are used to isolate adjacent gallium nitride components.

In a possible implementation, S2 may be implemented by using thin film preparation and a photolithography technique, and an implementation manner of S2 may include but is not limited to the following steps.

S21: Form a patterned photoresist layer on a surface that is of the non-active region and that is away from a surface of the substrate.

S22: Use the patterned photoresist layer as a mask, etch the non-active region, and expose the substrate to obtain the plurality of grooves.

It should be understood that in another layer structure in the chip, a proper thin film preparation method may be selected based on a material of the another layer structure, and a thin film layer may be patterned by using a image composition process such as a photolithography process, which are not limited in this embodiment of this application.

The foregoing substrate may be a silicon substrate, or may be a sheet formed of materials such as quartz, alumina, silicon nitride, and silicon carbide.

The transition layer may be of a material such as aluminum nitride, silicon nitride, or silicon carbide, and may be formed by a thin film preparation technique.

Metal stack or an electrode layer material includes metals such as nickel, gold, silver, platinum, tungsten, copper, titanium, and aluminum, or alloys of the matals. It may be formed by using a coating process such as electron beam evaporation or sputtering and a photolithography process.

A material of a dielectric layer may be any one or a combination of a plurality of insulating materials such as HfO₂, ZrO₂, Al₂O₃, SiO₂ and Si₃N₄, and may be formed by a thin film preparation technique.

A material of a passivation layer may be an inorganic insulating material, and may be formed by a thin film preparation process. A material of the passivation layer may also be an organic insulating material, which may be formed by a thin film preparation technique such as a spin coating technique, a chemical vapor deposition technique, or a physical vapor deposition technique.

It should be understood that in each embodiment of the present invention, the patterning refers to an image composition process, and may include a photolithography technique, or may include a photolithography technique and etching steps, or may further include another technique, such as printing or ink jet, used to form a predetermined graphic. The photolithography technique is a technique that includes a process of film forming, exposing, developing, and peeling, and forms a graphic by using a photoresist, a mask, an exposure machine, and the like. A corresponding composition process may be selected based on a structure formed in the present invention.

It should be understood that, in each embodiment of the present invention, an etching process includes a dry etching process and a wet etching process. The dry etching process is a process of removal of erosion of an etched material by using a chemical reaction and a physical reaction between the etched material and particles in plasma. A dry etching manner includes plasma etching, reactive ion etching, inductively coupled plasma etching, and the like. A wet etching process is an etching method in which an etched substance is peeled off by a chemical reaction between the chemical solution and the etched substance. A corresponding etching process may be selected based on a structure formed in the present invention.

It should be noted that the flowcharts described in embodiments of the present invention are only one embodiment. Without departing from the spirit of the present invention, the steps in each flowchart may be modified or changed in a plurality of ways, such as performing the steps in the flowchart in different order, or deleting, adding, or modifying specific steps.

The technical terms used in embodiments of the present invention are only used to describe specific embodiments but are not intended to limit the present invention. In this specification, the singular forms "one", "this", and "the" are used to include plural forms at the same time, unless otherwise stated in the context. Further, the "including" and/or "comprising" used in the specification refers to the presence of the features, entirety, steps, operations, elements and/or components, but does not rule out the presence or addition of one or more other features, entirety, steps, operations, elements and/or components.

The equivalent forms of the corresponding structure, material, action, and all apparatus or steps and functional elements (if exist) in the appended claims are intended to include any structure, material, or action used to perform the function in connection with other expressly required elements. The description of the present invention is given for the purposes of the embodiments and descriptions, but is not intended to be exhaustive or to be limited to the disclosed form of the invention.

## Claims

1. A gallium nitride-based chip, comprising: a substrate and a plurality of gallium nitride components disposed on the substrate, wherein the plurality of gallium nitride components are arranged in an array, each gallium nitride component of the plurality of gallium nitride components comprises an active region and a non-active region separately disposed on the substrate, the non-active region surrounds a side surface of the active region, the active region comprises at least one heterojunction formed by a gallium nitride layer and an aluminum gallium nitride layer, the non-active region comprises a plurality of grooves spaced apart, the plurality of grooves penetrate the non-active region and expose the substrate, and the plurality of grooves are used to isolate adjacent gallium nitride components.

2. The chip according to claim 1, wherein a ratio of a sum of areas of the plurality of grooves to an area of the non-active region is not less than 2/3.

3. The chip according to claim 1 or 2, wherein the non-active region further comprises a metal stack, and the metal stack comprises at least one metal layer stacked at intervals in a first direction; and each metal layer of the at least one metal layer is annular, and each metal layer is disposed between the plurality of grooves and the active region.

4. The chip according to any one of claims 1 to 3, wherein the gallium nitride layer comprises a first gallium nitride portion and a second gallium nitride portion that are both disposed on the substrate, the aluminum gallium nitride layer is disposed on a surface that is of the first gallium nitride portion and that is away from the substrate, and the first gallium nitride portion and the aluminum gallium nitride layer form the heterojunction; and the non-active region comprises the second gallium nitride portion, and the groove penetrates the first gallium nitride portion.

5. The chip according to claim 4, wherein the active region further comprises a source, a drain, and a gate, the source and the drain are respectively connected to two ends of the first gallium nitride portion, and the gate is connected to the aluminum gallium nitride layer.

6. The chip according to claim 4, wherein the active region further comprises a source, a drain, a gate, and a P-type gallium nitride layer, the P-type gallium nitride layer is disposed on a surface that is of the aluminum gallium nitride layer and that is away from the first gallium nitride portion, the source and the drain are respectively connected to two ends of the first gallium nitride portion, and the gate is connected to the P-type gallium nitride layer.

7. The chip according to claim 6, wherein the gallium nitride component further comprises a dielectric layer that covers the aluminum gallium nitride layer and the second gallium nitride portion, the dielectric layer comprises a first dielectric portion and a second dielectric portion, the first dielectric portion is a portion that is in the dielectric layer and corresponding to the first gallium nitride portion, and the second dielectric portion is a portion that is in the dielectric layer and corresponding to the second gallium nitride portion; and the source is connected to one end of the first gallium nitride portion through a first hole passing through the dielectric layer, the drain is connected to the other end of the first gallium nitride portion through a second hole passing through the dielectric layer, the gate is connected to the P-type gallium nitride layer through a third hole passing through the dielectric layer, the non-active region comprises the second dielectric portion, and the groove further penetrates the second dielectric portion.

8. The chip according to claim 7, wherein the gallium nitride component further comprises a passivation layer, the passivation layer is disposed on a surface of the dielectric layer that is away from the substrate, and the passivation layer is provided with a hole used to expose the source, the drain, and the gate; and the groove further penetrates the passivation layer.

9. The chip according to any one of claims 1 to 8, wherein the gallium nitride component further comprises a transition layer, the transition layer is disposed between the substrate and the gallium nitride layer, a lattice constant of the transition layer falls between a lattice constant of the substrate and a lattice constant of the gallium nitride layer, and the groove further penetrates the transition layer.

10. The chip according to any one of claims 1 to 9, wherein adjacent two of the gallium nitride components further comprise a cutting area.

11. A gallium nitride power device, comprising the gallium nitride component obtained through cutting of the chip according to any one of claims 1 to 10.

12. A circuit, comprising the gallium nitride power device according to claim 11.

13. A chip preparation method, comprising:
forming a plurality of gallium nitride components on a substrate, wherein the plurality of gallium nitride components are arranged in an array, each gallium nitride component of the plurality of gallium nitride components comprises an active region and a non-active region separately disposed on the substrate, the non-active region surrounds a side surface of the active region, and the active region comprises at least one heterojunction formed by a gallium nitride layer and an aluminum gallium nitride layer; and
forming a plurality of grooves on the non-active region, wherein the plurality of grooves penetrate the non-active region and expose the substrate, and the plurality of grooves are used to isolate adjacent gallium nitride components.

14. The method according to claim 13, wherein the forming a plurality of grooves on the non-active region comprises:
forming a patterned photoresist layer on a surface that is of the non-active region and that is away from the substrate; and
using the patterned photoresist layer as a mask, etching the non-active region, and exposing the substrate to obtain the plurality of grooves.
